# EUROPEAN PATENT SPECIFICATION

(11) **EP 0 422 744 B1**
(45) Date of publication and mention of the grant of the patent: **21.09.1994**
(21) Application number: 90202721.8
(22) Date of filing: 11.10.1990
(51) Int. Cl.: H05K 3/30, H01R 23/68, H01R 23/70, H01R 13/74, H01R 23/72

(54) **A latching means and an electrical circuit component with such a latching means for mounting to a substrate**
Einrastvorrichtung für die Montage auf einer Platine und damit versehenes elektrisches Bauteil
Moyen d'accrochage pour le montage sur une plaquette de circuits et composant élèctrique ménagé d'un tel moyen

(30) Priority: 11.10.1989 NL 8902522
(43) Date of publication of application: 17.04.1991
(73) Proprietor: CONNECTOR SYSTEMS TECHNOLOGY N.V., Willemstad, Curaçao (AN); DU PONT DE NEMOURS (NEDERLAND) B.V., 3300 AC Dordrecht (NL)
(72) Inventor: Verhoeven, Laurentius Maria, NL-5465 RV Veghel (NL)
(74) Representative: de Bruijn, Leendert C.

(56) References cited:
- DE-B- 1 069 724
- FR-A- 2 315 781
- FR-A- 2 353 970
- US-A- 4 435 031
- SIEMENS COMPONENTS. vol. 24, no. 3, June 1989, MUNCHEN DE page 126"Connectorsto DIN 41612 with securing clips."

## Description

The invention relates to a latching means for an electrical circuit component to be latched to a substrate, the latching means comprising at least one latching member having a base and two resilient legs extending in the same direction away from said base and attempting to assume a deflected position with respect to each other as a result of their resiliency, at their free ends the legs being provided with shoulders, in use the base of the latching member acts upon the circuit component and the shoulders act on a side of the substrate.

A latching means of this type is known, inter alia, from FR-A-2,315,781.

Prior to soldering, electrical circuit components such as connectors, switches, relays and certain electronic circuit components are generally mounted on a printed circuit board by means of small bolts and nuts or rivets. In many cases, this mounting only serves to hold the respective circuit component in place during soldering in order to prevent faulty soldering connections.

Mounting with small bolts and nuts is relatively expensive and time consuming. The use of rivets requires a special tool. There is also the risk that the circuit component or the printed circuit board may break or crack due to the forces exerted thereon when securing with a rivet. This method of mounting is also relatively expensive.

With the latching means according to said FR-A-2,315,781 the above-mentioned disadvantages regarding the use of bolts and rivets have been largely overcome. However, these known latching means are made of sheet metal having shoulders of which the part acting on the substrate extend at substantially right angles to the legs. Tolerance differences in the thickness of the substrate and the housing at the position of the mounting apertures, and also in the length of the legs may result in a loose fitting, in case of undersized thicknesses, or in that no latching at all is possible due to oversized thicknesses, for example. In the latter case there is also a risk of damaging the substrate when mounting the circuit component.

In case of a loose fitting there is a risk of an opening between the substrate and the housing of the circuit component, for example a connector, after soldering the terminals thereof. In contacting the connector by a further connector, indesired bending forces may be excerted on the terminals due to said opening. In contacting a further connector of a rack system having means for guiding the printed circuit board, for example, this opening leads to a misalignment between the connector on the board and the further connector in the rack, with the risk of damaging the board and/or connectors. Further, for latching circuit components having housings of different thickness a plurality of these known latching members have to be provided and held in stock, having legs of suitable different size.

The invention is consequently based on providing a latching device with which electrical circuit components such as connectors and the like can be latched onto a substrate, for example a printed circuit board, in a manner which is easy and inexpensive from an assembly engineering point of view and without being troubled by tolerance requirements.

For this purpose, the invention provides a latching member of which the the base and the legs are constructed as a single wire-like member, the free end of each leg being flared outward to extend in opposite directions at an acute-angle with respect to the longitudinal axis of the legs to provide the shoulders, the legs being able to partly overlap each other when deflected toward each other.

Tolerance differences in the thickness of the substrate and the housing at the position of the mounting apertures, and also in the length of the legs of the latching member according to the invention, can easily be absorbed by the shape of the shoulders which diverges ourwards at an acute-angle. With the latching means according to the invention, the housing of the circuit component is firmly held and latched onto the substrate, without an undesired opening inbetween. Due to the fact that the legs being able to partly overlap when deflected toward each other, the shoulders can be made relatively long without the need for mounting apertures of large diameter.

Through suitable dimensioning of the resiliency, the risk of breakage or damage to the circuit component and/or the substrate mentioned earlier can essentially be eliminated. Further, by producing the latching member as a wire-like entity the circuit component also offers, according to the invention, the possibility of being mounted either mechanically or without special tools, for example by hand.

In an inexpensive and effective embodiment of the latching device according to the invention the free ends of the legs of the latching member are rounded so as to extend toward each other after said shoulders and wherein said base is eye-shaped. The rounded ends facilitate displacement of the latching device in a mounting aperture during assembly.

The latching device according to the invention can be manufactured either from plastic or metal. In order to be able to subject the respective circuit component to a soldering process a plastic with adequate heat resistance should be used. The metal embodiment has the advantage that the respective latching device can, if necessary, be secured by soldering to the substrate in order to effect a rigid mounting of the respective circuit component and to absorb mechanical forces acting on the circuit component.

The invention further relates to an electrical circuit component comprising a housing having at least one aperture accommodating a latching member of the type described above, the legs and shoulders of said latching member are deflected towards each other and inserted in said aperture.

In a further embodiment of an electrical circuit component for using the latching device according to the invention, the aperture of the housing has at least one recess in a wall thereof to hold the latching member in place prior to latching to the substrate. A component with latching devices hold therein in partially assembled form may be shipped or transferred to the final assembly point where the circuit component is to be mounted on a substrate.

In a still further embodiment of an electrical circuit component according to the invention, the housing is provided with means for excerting a force on the base of the latching member so as to move the latching member from its position in the aperture of the housing to the position where the legs are fully inserted through the mounting aperture in the substrate.

The invention relates particularly to an electrical circuit component being an electrical connector. The latching member enables the connector to be held in place on the circuit substrate, while the terminals of the connector are soldered to said substrate.

A further advantage of the latching device according to the invention is that it can be introduced into any desired mounting aperture, for example the same mounting apertures in the housing of the circuit component and the substrate as are intended for receiving small bolts and/or rivets.

By squeezing the legs of the latching member together against their resiliency, they can easily be introduced into the respective mounting apertures, after which they can be displaced further into the mounting aperture in the direction of the substrate of exerting a pressure force on the base part. In the final assembled state, the shoulders of the latching member act on the substrate, the base part thereof acting with a certain force on the circuit component under the influence of the resiliency of the latching member so that the circuit component is firmly held and latched onto the substrate.

Accordingly, the invention further relates to an assembly of an electrical circuit component latched to a substrate by a latching means as described above.

The invention also relates to an apparatus for inserting the latching member in an aperture of the housing of a circuit component, said apparatus comprising a magazine for receiving a stack of latching members, said magazine adjoining a funnel-shaped mouth, means provided for exerting a force on the base of each latching member placed in front of the mouth in a manner such that the legs of said latching member are displaced therein starting from the divergent section of the funnel-shaped mouth, in order to insert each latching member into the aperture of the electrical circuit component with pre-stressing of the legs.

An apparatus of this type can be provided either for inserting the latching member according to the invention by hand or by machine.

The invention is described in more detail below with reference to a preferred embodiment used in a connector as shown diagrammatically in the drawing.

Figure 1a shows, in perspective, a section of a connector having a latching member according to the invention to be fitted in a mounting aperture of the connector.

Figures 1b, c show, partly in cross-section, the latching member according to Figure 1a in the mounting aperture before and after mounting the connector on a substrate.

Figures 2a, b, c show, in perspective, partly in cross-section, the latching member according to Figure 1 before, during and after mounting respectively, the mounting aperture being provided with a recess for securely holding the latching member.

Figures 3a, b, c show, partially in cross-section, the latching member according to Figure 1, before and after mounting respectively, the connector being provided with means for mounting the latching member.

Figure 4 shows, in perspective, an embodiment of an apparatus for inserting a latching member according to the invention in a mounting aperture of a circuit component housing.

Figure 5 shows, partly in cross-section, a detail of the apparatus according to Figure 4 on an enlarged scale.

Although the invention is illustrated below with reference to a use in a connector, no limitation at all must be perceived therein for the use in other electrical circuit components for the purpose of latching them onto a substrate. Elements having the same or a comparable action and/or function are indicated by the same reference numerals.

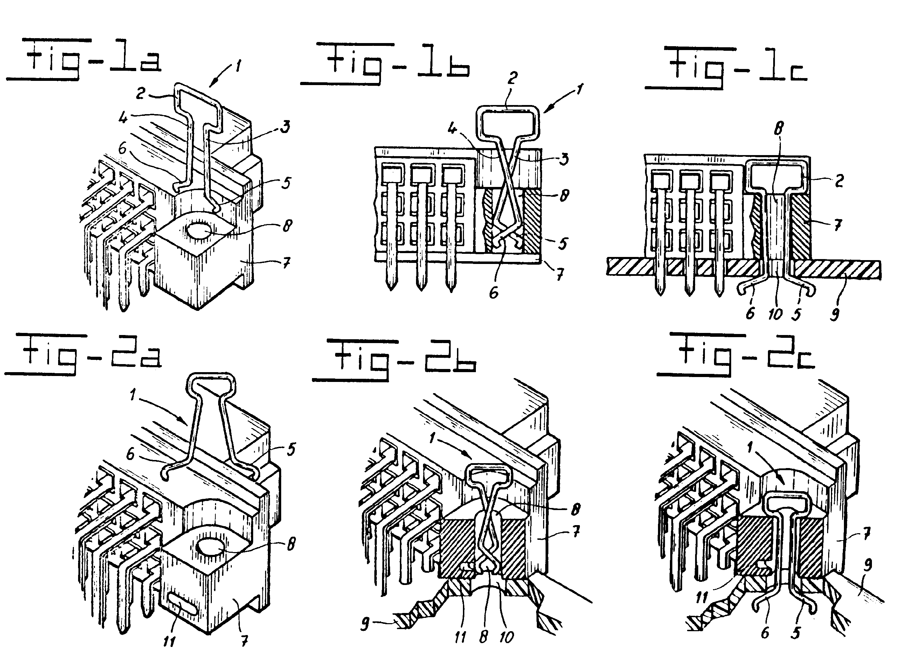

Figure 1a shows, in perspective, a preferred embodiment of the latching member according to the invention, indicated by the reference numeral 1. An eye-shaped base part 2 and legs 3, 4 are formed as a wire-type entity, for example from a resilient metal or a resilient plastic. The legs 3, 4 can be deflected with respect to each other due to their resiliency. The legs 3,4 are provided with shoulders 5 and 6, respectively, by deflecting the free ends thereof in the opposite direction at an acute-angle with respect to the longitudinal axis of the legs 3, 4. At their free ends, the shoulders 5, 6 are rounded by bending back the free ends in the direction of the longitudinal axis of the legs 3, 4. The latching member 1 is introduced into the mounting aperture 8 of the housing 7 of the connector.

Figure 1b shows, partly in cross-section, the latching member 1 introduced into the mounting aperture 8, the legs having a certain prestressing determined, inter alia, by the dimensions of the shoulders 5, 6 and the diameter of the mounting aperture 8. The latching member is introduced into the mounting aperture 8 simply by squeezing the legs 3, 4 together in an overlapping manner.

Figure 1c shows, partly in cross-section, the connector housing 7 latched onto a substrate 9, for example a printed circuit board, having a mounting aperture 10 by means of the latching member 1 according to the invention. From this figure it can be seen that the eye-shaped base part 2 of the latching member 1 acts on the housing 7 in the assembled state, while the shoulders 5, 6 act on the substrate 9 in the vicinity of the mounting,aperture 10. Tolerance differences in the thickness of the substrate 9 and the housing 7 at the position of the mounting apertures 8, 10, and also in the length of the legs 3, 4 can easily be absorbed by the shape of the shoulders which diverges outwards at an acute-angle. The latching member 1 can be removed from the mounting apertures 8, 10, if desired, by squeezing the legs 3, 4 together again in an overlapping manner.

Figures 2a, b, c also show the preferred embodiment of the latching member 1, but in this case, however, the mounting aperture 8 in the housing 7 of the connector is provided with a recess 11 for securely holding the latching member 1 in the mounting aperture 8 by means of the rounded shoulder ends thereof prior to the latching of the connector onto a substrate (Figure 2b). The connector may be shipped or transferred with the latching member in this partially assembled state until the connector is positioned at the substrate for mounting. Figure 2c shows the connector after it is latched onto the substrate 9 by means of the latching member 1 according to the invention.

Figures 3a, b, c show the mounting of a connector by a mechanical method in one or more mounting apertures 8 in which a latching member 1 according to the invention has previously been inserted. The whole connector is first positioned opposite the desired position on the substrate 9 by means of an arm 12 of a machine, for example a robot, which acts on the housing 7 of the connector (Figure 3a). After positioning the connector (Figure 3b) a force is exerted in the direction of the substrate 9 by means of the arm 12 on the base part 2 of the latching member 1 in order to latch the connector thereto. After mounting the connector, the arm 12 is removed again.

The housing 7 may, if necessary, be provided with means for exerting a force on the eye-shaped base part 2 of the latching member for latching the housing onto a substrate.

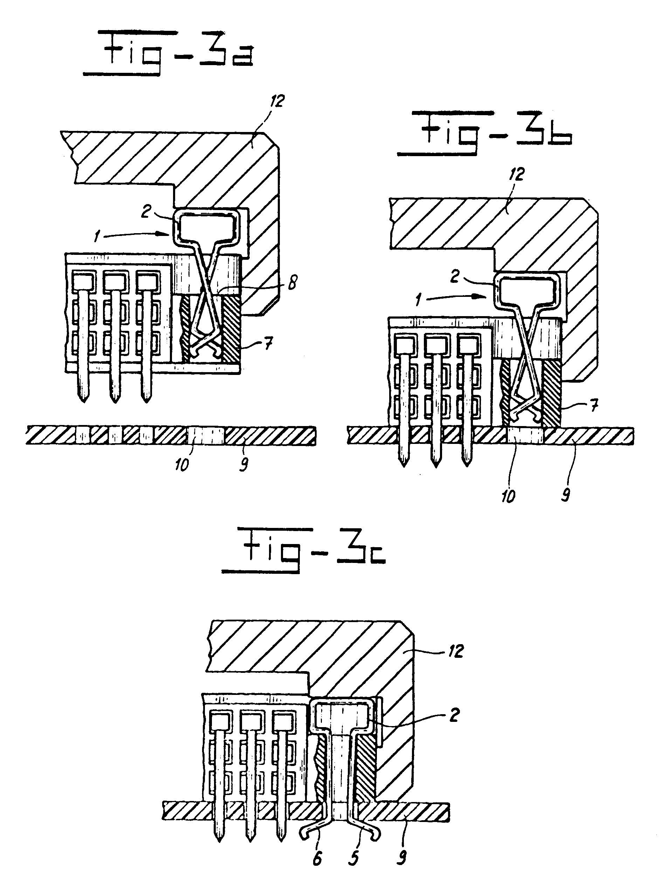

Figure 4 shows an apparatus with which the latching members according to the invention can easily be mounted. The apparatus comprises a magazine 33 in which a stack 34 of latching members may be fitted, which magazine 33 merges into a mouth 35. The latching member to be mounted, such as, for example, the latching member 1 according to Figure 1 of the invention and indicated by broken lines, is squeezed together and introduced into the mounting aperture 8 of the connector via said mouth 35 by exerting a force on the base part of the latching member with the lever 36.

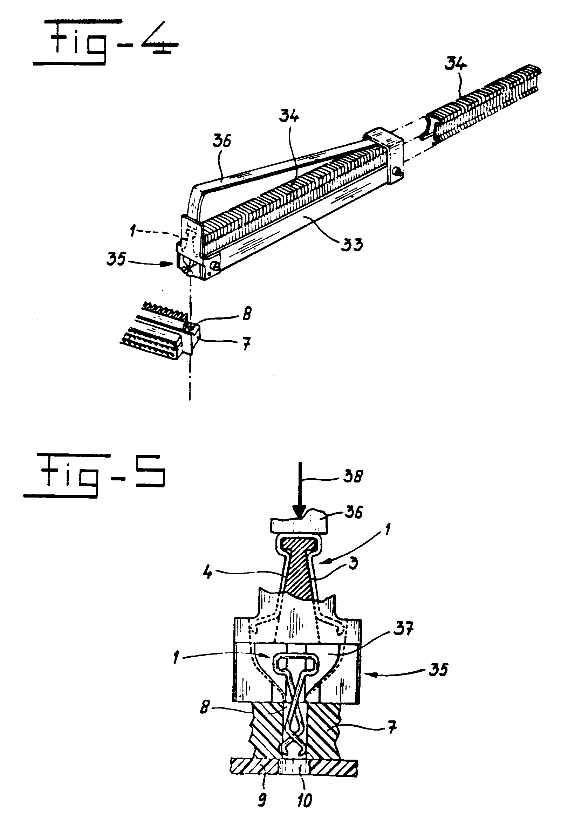

Figure 5 shows, partly in cross-section, on an enlarged scale, the mouth 35, which has a funnel-shaped part 37 into which the respective latching member 1 is introduced starting from the wide side with its legs 3, 4. As a result of exerting a force on the latching member 1 with the aid of the lever 36, as shown by the arrow 38, the legs 3, 4 are squeezed together in order to introduce the latching member 1 into the mounting aperture 8 of the housing 7.

The apparatus according to Figure 4 can be used for any of the embodiments of a latching member according to the invention by suitably shaping the mouth 35. The apparatus can be made suitable both for manual operation and for machine introduction of latching members.

The invention can be modified in various ways by a person skilled in the art without departing from the inventive idea in doing so. In this connection, consideration may be given to the shape of the base part, the way in which said base part acts on the circuit component, the shape of the shoulders, the joining of the legs together at, for example, their free ends, etc.

## Claims

1. A latching means for an electrical circuit component to be latched to a substrate (9), the latching means comprising at least one latching member (1) having a base (2) and two resilient legs (3, 4) extending in the same direction away from said base (2) and attempting to assume a deflected position with respect to each other as a result of their resiliency, at their free ends the legs (3, 4) being provided with shoulders (5, 6), in use the base (2) of the latching member (1) acts upon the circuit component and the shoulders (5, 6) act on a side of the substrate (9), characterized in that the base (2) and the legs (3, 4) of the latching member (1) are constructed as a single wire member, the free end of each leg (3, 4) being flared outward to extend in opposite directions at an acute-angle with respect to the longitudinal axis of the legs (3, 4) to provide the shoulders (5, 6), the legs (3, 4) being able to partly overlap each other when deflected toward each other.

2. A latching means according to claim 1, wherein the free ends of the legs (3, 4) of the latching member (1) are rounded so as to extend toward each other after said shoulders (5, 6) and wherein said base (2) is eye-shaped.

3. A latching means according to claim 1 or 2, wherein the latching member (1) is formed from plastic.

4. A latching means according to claim 1 or 2, wherein the latching member (1) is formed from metal.

5. An electrical circuit component provided with latching means according to any of the preceding claims, wherein the circuit component comprises a housing (7) having at least one aperture (8) accommodating a latching member (1), the legs (3, 4) and shoulders (5, 6) of said latching member (1) being deflected towards each other and inserted in said aperture (8).

6. An electrical circuit component according to claim 5, wherein the aperture (8) of the housing (7) has at least one recess (11) in a wall thereof to hold the latching member (1) in place prior to latching the circuit component to the substrate (9).

7. An electrical circuit component according to claim 5 or 6, wherein the housing (7) is provided with means (12) for exerting a force on the base (2) of the latching member (1) so as to move the latching member (1) from its position in the aperture (8) of the housing (7) to the position where the legs (3, 4) are fully inserted through a mounting aperture (10) in the substrate (9).

8. An electrical circuit component according to claim 5, 6 or 7, wherein said circuit component is an electrical connector.

9. An apparatus for inserting a latching member (1) according to any of the claims 1, 2, 3 or 4 in an aperture (8) of the housing (7) of a circuit component according to any of the claims 5, 6, 7 or 8, said apparatus comprising a magazine (33) for receiving a stack (34) of latching members (1) said magazine (33) adjoining a funnel-shaped mouth (35), and means (36) for exerting a force on the base (2) of each latching member (1) placed in front of the mouth (35) in a manner such that the legs (3, 4) of said latching member (1) are displaced therein starting from the divergent section of the funnel-shaped mouth (35), in order to insert each latching member (1) into the aperture (8) of the electrical circuit component with pre-stressing of the legs (3, 4).

10. An assembly of an electrical circuit component according to any of the claims 5, 6, 7 or 8, latched to a substrate (9) by a latching means according to any of the claims 1, 2, 3 or 4, wherein the circuit component is placed on a side of the substrate (9) such that an aperture (8) of the housing (7) of the circuit component is aligned with a mounting aperture (10) of the substrate (9), and the shoulders (5, 6) of a latching member (1) act on the other side of the substrate (9) while the base (2) of the latching member (1) acts upon the housing (7) of the circuit component.

## Patentansprüche

1. Rastvorrichtung für ein elektrisches Schaltungsbauteil, welches an einem Substrat (9) zu verrasten ist, wobei die Rastvorrichtung wenigstens ein Rastelement (1) mit einer Basis (2) und zwei federnd nachgiebigen Schenkeln (3, 4) aufweist, die in die gleiche Richtung von der Basis (2) weg weisen, und welche versuchen, eine ausgelenkte Position bezüglich einander infolge ihres Federungsvermögens einzunehmen, wobei die Schenkel (3, 4) an ihren freien Enden mit Schultern (5, 6) versehen sind, wobei im Gebrauchszustand die Basis (2) des Rastelements (1) auf das Schaltungsbauteil einwirkt und die Schultern (5, 6) auf eine Seite des Substrats (9) einwirken, dadurch gekennzeichnet, daß die Basis (2) und die Schenkel (3, 4) des Rastelements (1) in Form eines einzelnen Drahtteils ausgelegt sind, das freie Ende des Schenkels (3, 4) nach außen erweitert ist, um sich in Gegenrichtungen unter einem spitzen Winkel bezüglich der Längsachse der Schenkel (3, 4) zu erstrecken und die Schultern (5, 6) zu bilden, und daß sich die Schenkel (3, 4) teilweise miteinander überlappen können, wenn sie aufeinander zu gebogen sind.

2. Rastvorrichtung nach Anspruch 1, bei der die freien Enden der Schenkel (3, 4) des Rastelements (1) derart abgerundet sind, daß sie nach den Schultern (5, 6) aufeinander zu verlaufen, und bei der die Basis (2) augenförmig ausgebildet ist.

3. Rastvorrichtung nach Anspruch 1 oder 2, bei der das Rastelement (1) aus Kunststoff ausgebildet ist.

4. Rastvorrichtung nach Anspruch 1 oder 2, bei der das Rastelement (1) aus Metall ausgebildet ist.

5. Elektrisches Schaltungsbauteil, welches mit einer Rastvorrichtung nach einem der vorangehenden Ansprüche versehen ist, wobei das Schaltungsbauteil ein Gehäuse (7) aufweist, welches wenigstens eine Öffnung (8) zur Aufnahme eines Rastelements (1) hat, und wobei die Schenkel (3, 4) und die Schultern (5, 6) des Rastelements (1) aufeinanderzu gebogen und in die Öffnung (8) eingeführt sind.

6. Elektrisches Schaltungsbauteil nach Anspruch 5, bei dem die Öffnung (8) des Gehäuses (7) wenigstens eine Ausnehmung (11) in einer Wand hiervon hat, um das Rastelement (1) vor der Verrastung des Schaltungsbauteils mit dem Substrat (9) an Ort und Stelle zu halten.

7. Elektrisches Schaltungsbauteil nach Anspruch 5 oder 6, bei dem das Gehäuse (7) mit einer Einrichtung (2) zum Aufbringen einer Kraft auf die Basis (2) des Rastelements (1) derart versehen ist, daß das Rastelement (1) von seiner Position in der Öffnung (8) des Gehäuses (7) zu einer Position bewegbar ist, in der die Schenkel (3, 4) vollständig durch eine Montageöffnung (10) in das Substrat (9) eingeführt sind.

8. Elektrisches Schaltungsbauteil nach Anspruch 5, 6 oder 7, bei dem das Schaltungsbauteil eine elektrische Verbindung ist.

9. Einrichtung zum Einführen eines Rastelements (1) nach einem der Ansprüche 1, 2, 3 oder 4 in eine Öffnung (8) des Gehäuses (7) eines Schaltungsbauteils nach einem der Ansprüche 5, 6, 7 oder 8, wobei die Einrichtung ein Magazin (33) zur Aufnahme eines Stapels (34) von Rastelementen (1) aufweist, das Magazin (33) an eine trichterförmige Mündung (35) angrenzt, und eine Vorrichtung (36) zum Aufbringen einer Kraft auf die Basis (2) jedes Rastelements (1) vor der Mündung (35) derart angeordnet ist, daß die Schenkel (3, 4) des Rastelements (1) darin ausgehend von einem divergierenden Teil der trichterförmigen Mündung (35) verlagert werden, um jedes Rastelement (1) in die Öffnung (8) des elektrischen Schaltungsbauteils unter einer Vorbelastung der Schenkel (3, 4) einzuführen.

10. Anordnung mit einem elektrischen Schaltungsbauteil nach einem der Ansprüche 5, 6, 7 oder 8, welches an einem Substrat (9) mit Hilfe einer Rastvorrichtung nach einem der Ansprüche 1, 2, 3 oder 4 verrastet ist, bei der das Schaltungsbauteil auf einer Seite des Substrats (9) derart angeordnet ist, daß eine Öffnung (8) des Gehäuses (7) des Schaltungsbauteils zu einer Montageöffnung (10) des Substrats (9) fluchtet, und die Schultern (5, 6) eines Rastelements (1) auf eine Seite des Substrats (9) einwirken, während die Basis (2) des Rastelements (1) auf das Gehäuse (7) des Schaltungsbauteils einwirkt.

## Revendications

1. Moyens de verrouillage pour un composant de circuit électrique à verrouiller à un substrat (9), les moyens de verrouillage comprenant, au moins, un organe de verrouillage (1) muni d'une base (2) et de deux branches élastiques (3, 4) s'étendant dans la même direction à partir de ladite base (2) et tendant à prendre une position fléchie l'une par rapport à l'autre par suite de leur élasticité, les branches (3, 4) étant pourvues à leurs extrémités libres, d'épaulements (5, 6), et en service, la base (2) de l'organe de verrouillage (1) agissant sur le composant du circuit tandis que les épaulements (5, 6) agissent sur une face du substrat (9), caractérisé en ce que la base (2) et les branches (3, 4) de l'organe de verrouillage (1) sont réalisées sous la forme d'un organe monobloc en fil, l'extrémité libre de chaque branche (3, 4) étant écartée vers l'extérieur de manière à s'étendre dans des directions opposées, à angle aigu par rapport à l'axe longitudinal des branches (3, 4) pour former les épaulements (5, 6), les branches (3, 4) étant susceptibles de se recouvrir mutuellement en partie lorsqu'elles sont infléchies l'une vers l'autre.

2. Moyens de verrouillage selon la revendication 1, dans lesquels les extrémités libres des branches (3, 4) de l'organe de verrouillage (1) sont arrondies de manière à s'étendre l'une vers l'autre au delà desdits épaulements (5, 6) et dans lesquels ladite base (2) est en forme d'oeillet.

3. Moyens de verrouillage selon la revendication 1 ou 2, dans lesquels l'organe de verrouillage (1) est réalisé en matière plastique.

4. Moyens de verrouillage selon la revendication 1 ou 2, dans lesquels l'organe de verrouillage (1) est réalisé en métal.

5. Un composant de circuit électrique pourvu de moyens de verrouillage selon l'une quelconque des précédentes revendications, dans lequel le composant de circuit comprend un boîtier (7) pourvu d'au moins une ouverture (8) recevant un organe de verrrouillage (1), les branches (3, 4) et les épaulements (5, 6) dudit organe de verrouillage (1) étant infléchis l'un vers l'autre et introduits dans ladite ouverture (8).

6. Un composant de circuit électrique selon la revendication 5, dans lequel l'ouverture (8) du boîtier (7) comprend au moins une cavité (11) dans une paroi du boîtier, pour maintenir en place l'organe de verrouillage (1) avant de verrouiller le composant de circuit sur le substrat (9).

7. Un composant de circuit électrique selon la revendication 5 ou 6, dans lequel le boîtier (7) est pourvu de moyens (12) pour exercer une force sur la base (2) de l'organe de verrouillage (1) de manière à déplacer l'organe de verrouillage (1) à partir de sa position dans l'ouverture (8) du boîtier (7) jusqu'à la position dans laquelle les branches (3, 4) sont entièrement introduites dans une ouverture de montage (10) du substrat (9).

8. Un composant de circuit électrique selon les revendications 5, 6 ou 7, dans lequel ledit composant de circuit est un connecteur électrique.

9. Un appareil d'introduction d'un organe de verrouillage (1) selon l'une quelconque des revendications 1, 2, 3 ou 4 dans une ouverture (8) du boîtier (7) d'un composant de circuit selon l'une quelconque des revendications 5, 6, 7 ou 8, ledit appareil comprenant un magasin (33) pour recevoir un empilement (34) d'organes de verrouillage (1), ledit magasin (33) étant adjacent à une embouchure en forme goulotte (35), et des moyens (36) pour exercer une force sur la base (2) de chaque organe de verrouillage place à l'avant de l'embouchure (35), de telle manière que les branches (3, 4) dudit organe de verrouillage (1) soient déplacés à l'intérieur, à partir de le section divergente de l'embouchure en forme de goulotte (35), de manière à introduire chaque organe de verrouillage (1) dans l'ouverture (8) du composant de circuit électrique avec une précontrainte des branches (3, 4).

10. Un ensemble de composant de circuit électrique selon l'une quelconque des revendications 5, 6, 7 ou 8, verrouillé à un substrat (9) par des moyens de verrouillage selon l'une quelconque des revendications 1, 2, 3 ou 4, dans lequel le composant de circuit est placé sur une face du substrat (9), de telle manière qu'une ouverture (8) du boîtier (7) du composant de circuit soit dans l'alignement d'une ouverture de montage (10) du substrat (9) et que les épaulements (5, 6) d'un organe de verrouillage (1) agissent sur l'autre face du substrat (9) tandis que la base (2) de l'organe de verrouillage (1) agit sur le boîtier (7) du composant de circuit.
